# EUROPÄISCHE PATENTSCHRIFT

(11) **EP 2 520 988 B1**
(45) Veröffentlichungstag und Bekanntmachung des Hinweises auf die Patenterteilung: **23.11.2016**
(21) Anmeldenummer: 11003758.7
(22) Anmeldetag: 06.05.2011
(51) Int. Cl.: G01R 19/25, G01R 31/00, G05B 9/02, G01R 35/00

(54) **Überwachungseinrichtung für Netzwächter**
Monitoring device for mains monitors
Dispositif de surveillance de systèmes de surveillance de réseaux électriques

(43) Veröffentlichungstag der Anmeldung: 07.11.2012
(73) Patentinhaber: Schuster Energieversorgungssysteme GmbH & Co.KG, 41515 Grevenbroich (DE)
(72) Erfinder: Wich, Jens, 41472 Neuss (DE)
(74) Vertreter: Lenzing Gerber Stute

(56) Entgegenhaltungen:
- EP-A1- 1 513 376
- EP-A2- 0 939 476
- DE-C- 700 686
- Eberle: "Mess- und Überwachungsrelais für Profis", , 31. Juli 2009 (2009-07-31), XP55007617, Gefunden im Internet: URL:http://www.eberle.de/WorkArea/Download Asset.aspx?id=5097 [gefunden am 2011-09-20]

## Beschreibung

Die vorliegende Erfindung betrifft ein System zur Überwachung von mindestens zwei Netzwächtern, eine Steuereinheit und eine elektrische Meldeleitung aufweisend, wobei jeder Netzwächter jeweils ein Netzwächter-Schaltmittel aufweist, mit dem die elektrische Meldeleitung unterbrechbar ist, sobald der Netzwächter einen zu großen Spannungsabfall an zumindest einer elektrischen Versorgungsleitung detektiert, und die Meldeleitung mit ihren Enden mit einem Ausgang und einem Eingang der Steuereinheit verbunden ist, wobei die Steuereinheit bei detektierter Unterbrechung der Meldeleitung eine Aktion auslöst.

Unter einem Netzwächter im Sinne der Erfindung wird eine elektrische Einheit verstanden, die fortlaufend überprüft, ob an einer Phase eines ein- oder mehrphasigen Netzes eine genügend große Spannung anliegt. Sobald eine bestimmte Spannung unterschritten wird, löst der erfindungsgemäße Netzwächter einen Alarm aus. Der erfindungsgemäße Netzwächter ist über eine elektrischen Meldeleitung mit einer Steuereinheit verbunden, wobei der Netzwächter ein Netzwächter-Schaltmittel aufweist, mit dem die Meldeleitung im Falle eines Alarms unterbrochen wird. Die Meldeleitung ist oft eine einpolige elektrische Leitung, die mit ihrem einen Ende mit einem Ausgang der Steuereinheit und mit ihrem anderen Leitungsende mit einem Eingang der Steuereinheit verbunden ist. Auf den Ausgang legt die Steuereinheit dauerhaft ein Spannungspotential. In die Meldeleitung können mehrere Schaltmittel von Netzwächtern eingeschliffen, d.h. in Reihe geschaltet werden. Sobald ein Netzwächter sein Netzwächter-Schaltmittel öffnet, liegt am Eingang der Steuereinheit nicht mehr das Spannungspotential des Ausgangs der Steuereinheit an, was von der Steuereinheit als Ausfall einer von einem Netzwächter überwachten Phase angesehen wird, woraufhin die Steuereinheit eine Aktion und/oder einen Alarm auslöst. Entsprechende Netzwächter werden z.B. in Notbeleuchtungssystemen verwendet.

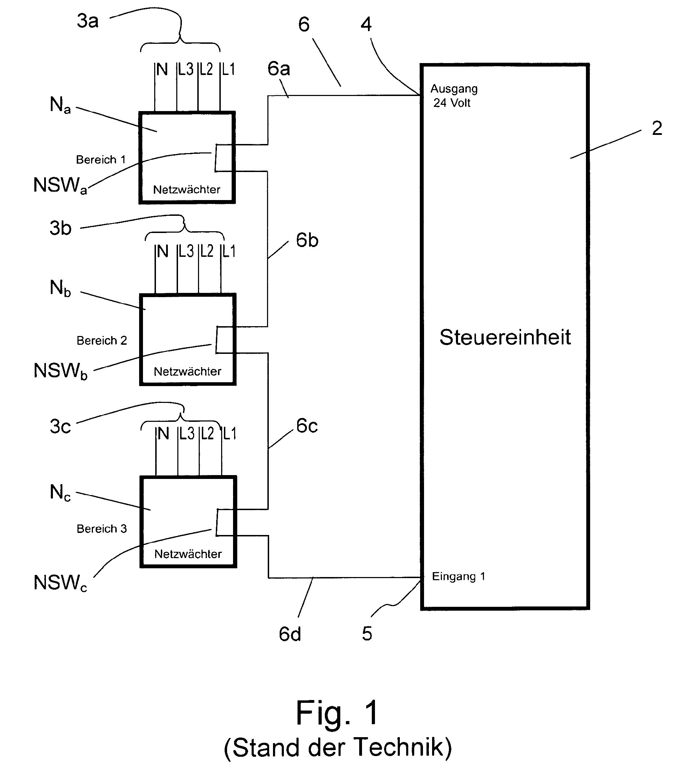

Ein gattungsgemäßes System ist in Figur 1 dargestellt. Das System besteht aus mehreren Netzwächtern N_{A}, N_{B}, N_{C}, welche jeweils die Phasen 3a, 3b und 3c (L1, L2, L3) überwachen. Jeder Netzwächter N_{A}, N_{B}, N_{C}, weist ein Netzwächter-Schaltmittel NSW_{a,b,c} auf, welche in die Meldeleitungsschleife 6 eingeschliffen sind. Die Meldeleitung 6 ist mit ihrem Anfang mit dem Ausgang 4 und mit ihrem Ende mit dem Eingang 5 der Steuereinheit 2 verbunden. Alle Netzwächter-Schaltmittel NSW_{a,b,c} sind bei korrekt anliegender Netzversorungsspannung geschlossen, so dass der 24V-Pegel an Ausgang 4 auch am Eingang 5 anliegt. Sobald ein Netzwächter Nᵢ sein Netzwächter-Schaltmittel NSW_{a,b,c} öffnet, ist die Meldeleitung 6 unterbrochen und am Eingang 5 liegt nicht mehr der Ausgangspegel von 24V an, was von der Steuereinheit 2 als Fehler interpretiert und eine entsprechende Aktion ausgelöst wird.

Nachteilig bei dem vorbeschriebenen System ist, dass zwar die Phasen mittels einer einfachen Eindrahtleitung überwacht werden können, dass aber die Funktion der Netzwächter selbst nicht überwacht werden können, ohne das evtl. zusätzliche Leitungen oder Funkstrecken verwendet werden. Zudem ist es nicht möglich, evtl. vorhandene Kurzschlüsse der als Eindrahtleitung ausgebildeten Meldeleitung zu erkennen.

Aufgabe der Erfindung ist es, ein gattungsgemäßes System derart weiter zu bilden, dass auch Fehler der Netzwächter von der Steuereinheit erkannt werden, so dass entsprechende Aktionen eingeleitet werden können.

Diese Aufgabe wird erfindungsgemäß mit einem System mit den Merkmalen des Anspruchs 1 gelöst. Weitere vorteilhafte Ausgestaltungen des Systems ergeben sich durch die Merkmale der Unteransprüche 2 bis 10. Die Merkmale der Verfahrensansprüche 11 bis 21 definieren Verfahren zur Verwendung, Programmierung bzw. automatischen Adressierung der Überwachungseinrichtungen des Systems sowie zur Durchführung von Funktionsüberwachungsroutinen, mit denen die Funktion der Überwachungseinrichtungen sowie der Netzwächter geprüft werden können.

Die erfindungsgemäße Überwachungseinrichtung kann in einem eigenen Gehäuse neben einem Netzwächter angeordnet werden. Es ist jedoch genauso gut möglich, dass die Überwachungseinrichtung Bestandteil eines Netzwächters ist.

Die Steuereinheit kann entweder über die Meldeleitung, eine gesonderte elektrische Leitung, wie z. B. einen Datenbus und/oder Adressbus oder über eine Funkübertragungsstrecke mit den Überwachungseinrichtungen kommunizieren. Sofern bereits eine Meldeleitung existiert, kann diese vorteilhaft ebenfalls zur Kommunikation zwischen Steuereinheit und den Überwachungseinrichtungen mit benutzt werden, so dass keine zusätzlichen Leitungen mehr verlegt werden müssen. Somit bietet sich das erfindungsgemäße System insbesondere für die Nachrüstung von bestehenden gattungsgemäßen Systemen an.

Die Überwachungseinrichtung kann über den Netzwächter oder unmittelbar aus dem Netz mit Betriebsspannung versorgt werden. Über die Meldeleitung kann die Überwachungseinrichtung angesteuert werden, so dass durch die Übermittlung von bestimmten Signalen oder Code-Wörtern bestimmte Funktionen oder Routinen ausgelöst bzw. gestartet und beendet werden können. Hierfür kann jede Überwachungseinrichtung vorteilhaft eine Pegelüberwachung der Meldeleitung aufweisen, so dass die Steuereinheit über die Meldeleitung Befehle oder Kommandos an die Überwachungseinrichtungen senden kann. Dabei kann der Eingangspegel der Meldeleitung, welche allgemein auch als Netzwächterschleife bezeichnet wird, auf den Nullleiter des Versorgungsnetzes der Netzwächter und des Steuercontrollers bezogen werden.

Die Überwachungseinrichtung weist vorteilhaft eine Steuereinrichtung auf, welche ein Schaltmittel ansteuert, mit dem die Meldeleitung unterbrechbar ist. Dieses Schaltmittel dient insbesondere der automatischen Adressvergabe für die einzelnen Überwachungseinrichtungen und/oder zur seriellen Funktionsüberprüfung des Systems und/oder zur Übermittlung von Daten an die Steuereinheit.

Die Steuereinrichtung der Überwachungseinrichtung verfolgt dabei permanent den Verlauf eines an der Meldeleitung anliegenden, insbesondere von der Steuereinheit erzeugten, Signals. In Abhängigkeit des Signals und/oder des Signalverlaufs wird dann von der Steuereinrichtung der Überwachungseinrichtung das Schaltmittel gesteuert. Das Öffnen des Schaltmittels hat zur Folge, dass die - ausgehend vom Ausgang der Steuereinheit - nachfolgend angeordneten Überwachungseinrichtung nicht mehr mit dem Ausgang der Steuereinheit verbunden sein können. Lediglich die in der Reihe erste Überwachungseinrichtung ist permanent mit dem Ausgang der Steuereinheit verbunden. Weitere Überwachungseinrichtungen sind nur dann ebenfalls mit dem Ausgang verbunden, wenn das Schaltmittel der davor geschalteten Überwachungseinrichtung(en) geschlossen ist. Diese Eigenschaft macht sich die Erfindung zu Nutze, um entweder die Adressierung der Überwachungseinrichtungen und/oder die Funktionsprüfung der einzelnen Netzwächter durchzuführen. Dabei kann durch die Steuereinheit ein Taktsignal oder Impulse auf die Meldeleitung gegeben werden, wobei die Takte/Impulse von den Überwachungseinrichtungen gezählt werden und in Abhängigkeit der jeweils gezählten Takte/Impulse eine Aktion ausgeführt wird. Dabei können die Überwachungseinrichtungen so programmiert oder geschaltet sein, dass sie nach dem Empfang einer bestimmten Anzahl empfangener Takten/Impulsen, z.B. 3 oder 5 Takte/Impulse, ihr Schaltmittel öffnen, so dass - wie vorbeschrieben - nur noch die in der Reihe erste Überwachungseinrichtung mit dem Ausgang der Steuereinheit verbunden ist. Gleichzeitig kommt das Taktsignal bzw. kommen die Impulse nicht mehr am Eingang der Steuereinheit an. Dies registriert die Steuereinheit und erkennt, dass nunmehr die Adressierung oder die nacheinander erfolgende Überprüfung der Netzwächter beginnt. So warten nach dem Öffnen der Schaltmittel die Netzwächter auf weitere Takte/Impulse. Erst nachdem die Netzwächter jeweils eine bestimmte vorgegebene Anzahl von Takten/Impulsen an ihrem Eingang gezählt haben, starten sie eine bestimmte Aktion oder schließen sie ihr Schaltmittel. Sobald sie ihr Schaltmittel geschlossen haben, ist die nachfolgende Überwachungseinrichtung mit dem Ausgang verbunden und "sieht" die Takte/Impulse auf der Meldeleitung und kann nun ebenfalls anfangen zu zählen. Sobald auch die in der Reihe letzte Überwachungseinrichtung ihr Schaltmittel wieder geschlossen hat, sieht auch die Steuereinheit die Takte/Impulse wieder an ihrem Eingang, wodurch die Steuereinheit weiß, dass alle Überwachungseinrichtung jeweils einmal ihr Schaltmittel geöffnet und wieder geschlossen haben. Sollte eine bestimmte Zeit überschritten werden, innerhalb derer am Eingang das Taktsignal bzw. die Impulse nicht wieder detektiert werden, so kann dies als Störung im System gewertet werden, wodurch ein entsprechender Alarm oder eine entsprechende Aktion ausgelöst wird.

Vorteilhaft hat die Überwachungseinrichtung neben dem Schaltmittel ein mindestens ein weiteres Test-Schaltmittel zur wahlweisen Unterbrechung einer zu überwachenden Versorgungsleitung. Die Steuereinrichtung der Überwachungseinrichtung steuert das Test-Schaltmittel. Sofern das Test-Schaltmittel geöffnet wird, muss der zugehörige Netzwächter einen Fehler anzeigen, da die jeweilige Versorgungsspannung nicht mehr korrekt anliegt. Der Netzwächter muss daher sein Netzwächter-Schaltmittel öffnen, was zur Unterbrechung der Meldeleitung führt. Die Unterbrechung kann vorteilhaft in einer weiteren Ausgestaltung der erfindungsgemäßen Überwachungseinrichtung ebenfalls von diesen detektiert werden.

Das Schaltmittel der Überwachungseinrichtung ist dabei vorteilhaft in Bezug auf den Ausgang der Steuereinheit seriell jeweils vor dem Netzwächter-Schaltmittel der von der Überwachungseinrichtung zu überwachenden Netzwächters in der Meldeleitung zu schalten. Hierdurch ist gewährleistet, dass bei geöffnetem Netzwächter-Schaltmittel die Überwachungseinrichtung stets noch das Signal der Steuereinheit sieht.

Die Überwachungseinrichtung kann zudem vorteilhaft Mittel zur Ermittlung des Spannungsabfalls am Netzwächter-Schaltmittel oder zur Durchgangsprüfung des Netzwächter-Schaltmittels aufweisen. Hierdurch kann die Überwachungseinrichtung im Zusammenspiel mit dem eigenen Test-Schaltmittel die korrekte Funktion des zu überwachenden Netzwächters überprüfen und gegebenenfalls das Ergebnis an die Steuereinheit über Funk oder über die Meldeleitung übertragen.

Sofern jeder Überwachungseinrichtung eine gesonderte Adresse zugeordnet ist und/oder zuordbar ist, können die Überwachungseinrichtungen jeweils gezielt durch Übermittlung einer Adresse und evtl. eines Steuercodes angesprochen und gesteuert werden. Die jeweilige Adresse kann entweder manuell eingestellt oder vorgegeben werden oder aber automatisch mittels eines entsprechenden Verfahrens zugeordnet werden.

Im Normalbetrieb gibt die Steuereinheit ein Spannungssignal, z.B. 24V Gleichspannung, über ihren Ausgang auf die Meldeleitung. Sobald ein Netzwächter einen Spannungsabfall an einer Versorgungsleitung detektiert, wird er sein Netzwächter-Schaltmittel öffnen, wodurch die Meldeleitung unterbrochen ist, und das Ausgangssignal nicht mehr am Eingang der Steuereinheit ankommt. Sofern die Netzwächter in einem Notbeleuchtungssystem Verwendung finden, kann dann eine Notstromversorgung eingeschaltet werden.

Vorteilhaft können mit dem erfindungsgemäßen System auch Kurzschlüsse in der Meldeleitung erkannt werden. Dies wird anhand der in den Figuren dargestellten Ausführungsbeispiele eingehender beschrieben.

Nachfolgend wird anhand von mehreren Ausführungsbeispielen die Erfindung näher erläutert.

Es zeigen:
- Fig. 1:: Aus dem Stand der Technik bekanntes System;
- Fig. 2:: erste mögliche Ausführungsform des erfindungsgemäßen Systems;
- Fig. 3:: Überwachungseinrichtung für ein System gemäß Figur 2;
- Fig. 4:: zweite mögliche Ausführungsform des erfindungsgemäßen Systems;
- Fig. 5:: Überwachungseinrichtung für ein System gemäß Figur 4.

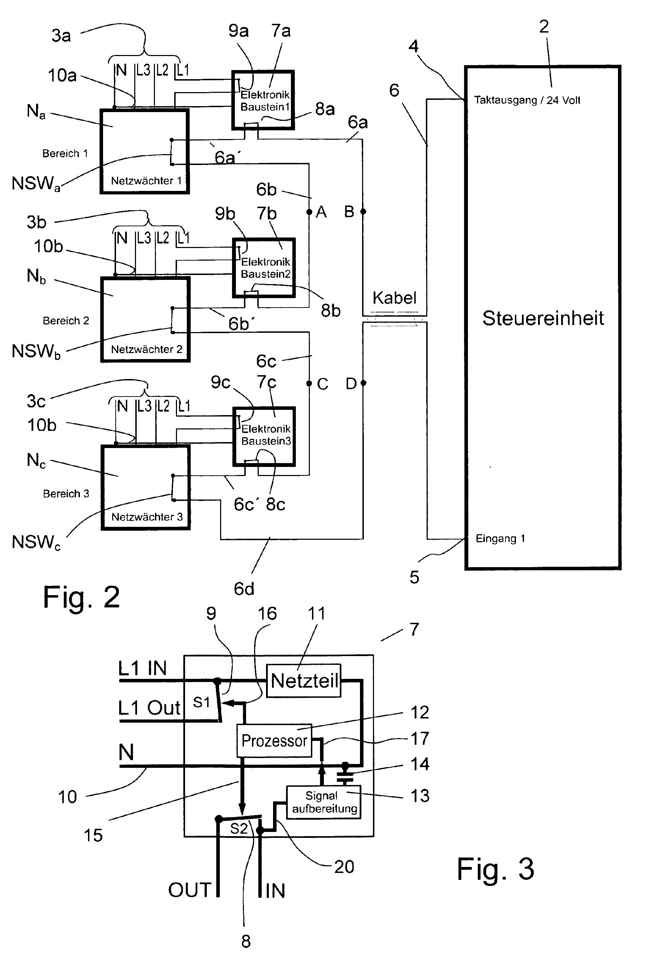

Die Figur 2 zeigt eine erste mögliche Ausführungsform des erfindungsgemäßen Systems. Die Netzwächter Nₐ, N_{b}, N_{c} sind über die Meldeleitung 6 mit der Steuereinheit 2 verbunden. Der grundsätzliche Aufbau unterscheidet sich daher nicht von dem Aufbau, wie er in der Figur 1 beschrieben und aus dem Stand der Technik bekannt ist. Im Unterschied zum System gemäß Figur 1 ist jedem Netzwächter Nₐ, N_{b}, N_{c} jeweils eine Überwachungseinrichtung 7a, 7b, 7c vorgeschaltet. Mit vorgeschaltet ist gemeint, dass das Schaltmittel 8a, 8b, 8c der jeweiligen Überwachungseinrichtung 7a, 7b, 7c mit dem Netzwächter-Schaltmittel NSWₐ, NSW_{b}, NSW_{c} in Reihe geschaltet ist, jedoch ausgehend vom Ausgang 4 vor dem jeweiligen Netzwächter-Schaltmittel NSWₐ, NSW_{b}, NSW_{c} angeordnet ist. Die Meldeleitung 6, welche auch als Netzwächterschleife bezeichnet werden kann, ist durch die Schaltmittel in die einzelnen Abschnitte 6a, 6a*'*, 6b, 6b*'*, 6c und 6c*'* unterteilt. Die Überwachungseinrichtungen 7a, 7b, 7c haben jeweils ein Test-Schaltmittel 9a, 9b, 9c, mit dem die Versorgungsleitung L1 auftrennbar ist. Durch das Auftrennen der Versorgungsleitung L1 kann die Funktion des jeweils zugehörigen Netzwächters Nₐ, N_{b}, N_{c} wahlweise getestet werden. Zusätzlich ist jede Überwachungseinrichtung 7a, 7b, 7c über eine Verbindungsleitung 10a, 10b, 10c mit dem Nulleiter der Versorgungsnetze 3a, 3b, 3c verbunden, so dass die Überwachungseinrichtungen 7a, 7b, 7c über die Versorgungsnetze 3a, 3b, 3c elektrisch versorgt werden. Es ist jedoch selbstverständlich auch möglich, dass die Überwachungseinrichtungen 7a, 7b, 7c über die Netzwächter Nₐ, N_{b}, N_{c} mit elektrischer Energie versorgt werden. Durch die direkte Versorgung über die Versorgungsnetze 3a, 3b, 3c ist jedoch sicher gestellt, dass diese auch bei einer Fehlfunktion der Netzwächter funktionieren.

Die Figur 3 zeigt eine Überwachungseinrichtung 7 für ein System gemäß Figur 2. Die Überwachungseinrichtung 7 verfügt über die Anschlüsse L1_IN, L1_Out, N, sowie IN und OUT. Über die Anschlüsse L1_IN und N wird die Überwachungseinrichtung 7 mit elektrischer Energie versorgt. Hierfür verfügt die Überwachungseinrichtung 7 ein Netzteil 11, welches der Überwachungseinrichtung 7 die richtige Betriebsspannung liefert. Der Anschluss L1_Out ist über das Test-Schaltmittel S1 bzw. 9 mit dem Anschluss L1_IN verbunden. Solange das Test-Schaltmittel 9 geschlossen ist, ist auch der zugehörige Netzwächter Nᵢ mit der Phase L1 verbunden. Die Überwachungseinrichtung 7 weist zudem eine Steuereinrichtung 12 mit einem Prozessor auf, die zur Signalverarbeitung und Ansteuerung der Schalter 8 und 9 dient. Die Schalter können dabei als Relais ausgebildet sein, welche über die Signalleitungen 15, 16 angesteuert werden. Zusätzlich weist die Überwachungseinrichtung 7 noch eine Signalaufbereitung 13 auf, die über die Signalleitung 20 das Spannungspotential und dessen Verlauf am Eingang IN überwacht. Die Steuereinrichtung 12 und die Signalaufbereitung 13 können selbstverständlich in einer Einheit oder durch einen Prozessor mit entsprechender Beschaltung zusammengefasst werden. Ein Filterkondensator 14 dient zum Ausfiltern von Spannungsspitzen, gegenüber dem Nullleiter 10.

Mittels des in der Figur 2 dargestellten Systems und der in Figur 3 dargestellten Überwachungseinrichtung 7 können folgende Funktionen ausgeführt werden:
A) Permanente Unterbruchprüfung
B) Permanente Kurzschlussprüfung
C) Überprüfung der einzelnen Netzwächter
D) Dauerbetriebsprüfung

Die einzelnen Funktionen werden nachfolgend im Detail beschrieben:

### A) Funktion "Permanente Unterbruchprüfung"

Eine Unterbrechung der Meldeleitung 6 wird auf jeden Fall erkannt, wenn der Pegel des Ausgangs 4 der Steuereinheit 2 nicht mehr dauerhaft am Eingang 5 anliegt. Dies ist dann der Fall, sofern ein Netzwächter Nᵢ sein Netzwächter-Schaltmittel NWSᵢ aufgrund eines Fehlers der Netzversorgung 3 geöffnet oder die Meldeleitung 6 durch einen anderen Fehler unterbrochen ist.

### B) Funktion "Permanente Kurzschlussprüfung"

Für die Kurzschlussprüfung taktet die Steuereinrichtung 12 jeder Überwachungseinrichtung 7 den am Ausgang 4 anliegende Gleichspannungspegel durch periodisches Ein- und Ausschalten des Schaltmittels 8, z. B. im Sekundentakt. Sollte der Takt aufgrund eines Kurzschluss zwischen A und B, oder C und B, oder D und B, oder im Kabel nicht mehr am Eingang 5 anliegen, so wird der dauernde 24 Voltpegel als Fehler der Meldeleitung 6 von der Steuereinheit 2 erkannt.

Ein Kurzschluss zwischen den Punkten A und C oder A und D wird durch die permanente Prüfung nicht erkannt. Diese Kurzschlüsse werden jedoch beim Netzwächtertagestest aufgrund falscher Taktlaufzeiten erkannt.

Die Funktion "Permanente Kurzschlussprüfung" kann durch Übermitteln eines Steuerwortes über die Meldeleitung 6 ausgelöst werden. Durch einen entsprechenden Stop-Befehl kann die Steuereinheit 2 die Funktion beenden. Auch ist es möglich, dass die Überwachungseinrichtungen nach einer gewissen Zeit automatisch in den normalen Überwachungsmodus mit geschlossenem Schaltmittel 8 wechseln.

### C) Funktion "Überprüfung der einzelnen Netzwächter"

Diese Funktion kann periodisch, z. B. einmal am Tag, durchgeführt werden. Dabei wird der normalerweise konstante 24V-Pegel in einer speziell vom Programm ausgelösten Routine von der Steuereinheit 2 getaktet, z.B. mit einem Takt von 500ms. Die Überwachungseinrichtungen 7 erkennen den Prüftakt und halten ihr internes Schaltmittel 8 geschlossen. Die Steuereinrichtungen 12 der Netzwächter "sehen" nun zunächst alle die von der Steuereinheit 2 ausgesendeten Impulse und fangen an diese zu zählen. Sobald alle Überwachungseinrichtungen 7 jeweils eine bestimmte Anzahl von Impulsen, z.B. 3 Impulse, gezählt haben, warten sie noch 1 Sekunde bis sie eine Phase L1 des zugehörigen Netzwächters Nᵢ mit ihrem Test-Schaltmittel 9 abschalten. Wenn der jeweilige Netzwächter Nᵢ in Ordnung ist, reagiert er darauf mit einem Öffnen seines Netzwächter-Schaltmittels NSWᵢ. Es sollte deshalb eine Sekunde gewartet werden, damit alle Überwachungseinrichtungen 7 jeweils die erfogerliche Anzahl von Impulsen "sehen" und der jeweiligen Netzwächter Nᵢ auch sicher auslöst. Nun erhält nur noch die Überwachungseinrichtung 7a die Taktimpulse und zählt diese weiterhin mit. Sie wartet wiederum eine Sekunde und schließt ihr Test-Schaltmittel 9a wieder, wodurch die Phase L1 wieder am Netzwächter Nₐ anliegt. Damit gelangen nach der Einschaltzeit des Netzwächters Nₐ die Impulse auch an der Überwachungseinrichtung 7b wieder an. Diese zählt nun ihrerseits auch die Impulse weiter auf und wartet wiederum eine Sekunde und schließt ihr Test-Schaltmittel 9b wieder, wodurch die Phase L1 wieder am Netzwächter N_{b} anliegt. Dieser Vorgang wiederholt sich solange, bis der letzte Netzwächter N_{c} sein Netzwächter-Schaltmittel NSW_{c} geschlossen hat und damit der Taktimpuls als positive Bestätigung an den Eingang 5 der Steuereinheit 2 gelangt. Damit ist die globale Überprüfung der Netzwächter Nᵢ inklusive ihrer Netzwächter-Schaltmittel NSWᵢ erfolgt. Falls ein Netzwächter Nᵢ nicht auslöst, oder sein Netzwächter-Schaltmittel NSWᵢ nicht öffnet, so kann aus der Abweichung der Zeit für den Test, verglichen mit der Zeit bei allen intakten Netzwächtern Nᵢ bei Inbetriebnahme der Netzwächter, ein Fehler erkannt werden.

Nach der Prüfroutine erzeugt die Steuereinheit 2 wieder einen konstanten Ausgangspegel von 24V. Sobald dies von der in der Reihe ersten Überwachungseinrichtung 7a erkannt worden ist, beginnt sie wieder mit der Takterzeugung gemäß Funktion D).

### D) Funktion "Takterzeugung durch die erste Überwachungseinrichtung"

Die Überwachungseinrichtung 7a die die von der Steuereinheit 2 ausgelösten Impulse "sehen" und zählen kann, auch wenn alle Überwachungseinrichtungen 7ᵢ ihr Schaltmittel 8 geöffnet haben, ist die erste Überwachungseinrichtung 7a. Diese Überwachungseinrichtung hat die Aufgabe, im Dauerbetrieb ein Taktsignal aus dem 24V-Konstantpegel der Steuereinheit 2 zu erzeugen. Dies geschieht durch periodisches Öffnen und Schließen des Schaltmittels 8a. Die Überwachungseinrichtung 7a muss nach Durchführen der Funktionen A), B) und C), wenn wieder dauernder Highpegel am Ausgang 4 anliegt, den Taktimpuls erzeugen. Genauso muss er die Takterzeugung sofort einstellen, wenn er den ersten Impuls der Steuereinheit 2 "sieht". Die nachfolgen in der Reihe geschalteten Überwachungseinrichtungen 7b, und 7c, welche identisch mit der ersten Überwachungseinrichtung 7a aufgebaut sind, haben mindestens eine Pause von einem Impuls bis zur Netzwächteranzahl Impulsen, weshalb sie keine Prüftakterzeugung initialisieren. Wenn die Spannungsversorgung der Überwachungseinrichtung 7a aufgrund eines Ausfalles der Netzspannung 3a wegfällt, würde sie nicht mehr takten können um einen Kurzschluss in der Netzwächterschleife zu erkennen. Dies ist jedoch nicht entscheidend, da in diesem Fall ein echter Netzausfall vorliegt und damit der zugehörige Netzwächter sein Netzwächter-Schaltmittel NSWᵢ öffnet und somit die Steuereinheit ohnehin eine Aktion auslöst.

Es ist selbstverständlich möglich, dass die Funktionen auch anders ausgebildet sein können. So ist es z. B. auch möglich, dass den einzelnen Überwachungseinrichtungen Adressen zugeordnet werden. Dies kann manuell oder auch automatisch erfolgen. So kann z.B. das Zählen der erkannten Impulse während der Funktion C) von den Überwachungseinrichtungen 7ᵢ dazu genutzt werden, sich selbst eine den gezählten Impulsen entsprechende Adresse zuzuordnen. Die Steuereinheit 2 kann anhand der insgesamt ausgesendeten bzw. erzeugten Impulse erkennen, wie viele Überwachungseinrichtungen 7ᵢ in der Meldeleitung 6 angeordnet sind und kann die Überwachungseinrichtungen 7ᵢ nach der Adressvergabe gezielt mittels Steuer- und Adressbefehlen ansprechen und zu bestimmten Aktionen veranlassen.

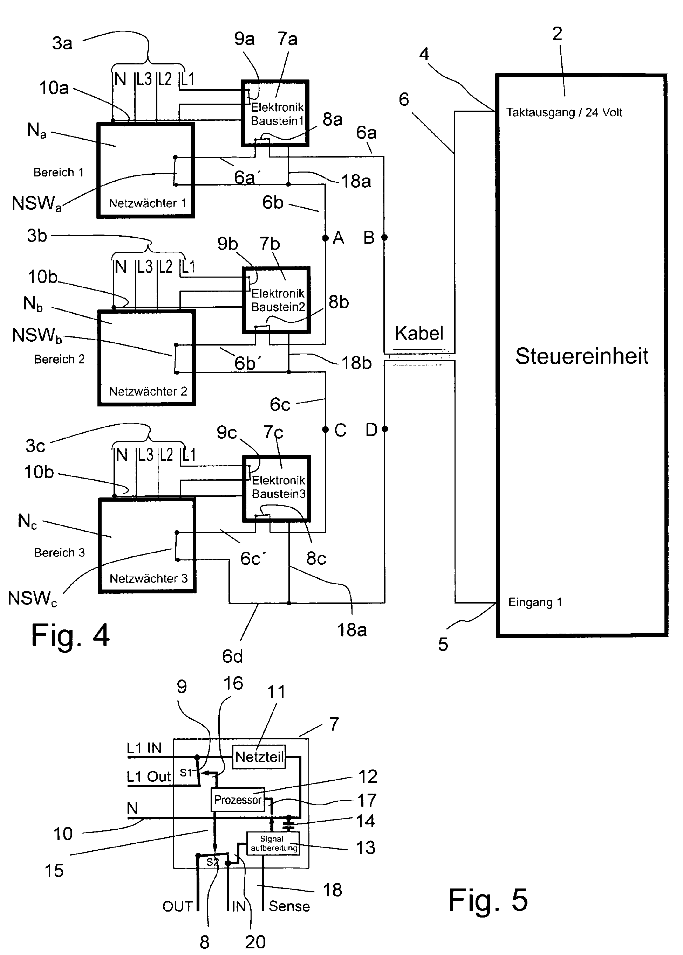

Die Figuren 4 und 5 zeigen eine zweite mögliche Ausführungsform des erfindungsgemäßen Systems, bei dem die Überwachungseinrichtungen 7ᵢ jeweils noch über einen Eingang 18ᵢ verfügen, mit dem der Schaltzustand des Netzwächter-Schaltmittels NSWᵢ überprüfbar ist. Über die Eingänge 18 und 20 kann die Steuereinrichtung 12 der jeweiligen Überwachungseinrichtung 7 einen Spannungsabfall am Netzwächter-Schaltmittels NSWᵢ überprüfen. Voraussetzung hierfür ist, dass das Schaltmittel 8 geschlossen ist. Es ist jedoch auch möglich, dass lediglich eine Durchgangprüfung vorgenommen wird.

Eine Adressierung der einzelnen Überwachungseinrichtungen 7ᵢ kann zum Beispiel mittels folgender Routine erfolgen:
Mit Impulsen erzeugt die Steuereinheit 2 ein Steuerwort, welches über die Meldeleitung 6 von allen Überwachungseinrichtungen 7i "gesehen" wird, worauf hin diese ihr internes Schaltmittel 8 öffnen. Daraufhin beginnt die Steuereinheit das Ausgangssignal zu takten bzw. Impulse zu senden. Diese können z.B. eine Impulslänge von 100ms aufweisen. Diese Impulse sieht daraufhin lediglich nur noch die in der Reihe erste Überwachungseinrichtung 7a, da sie die einzige ist, die noch über die Meldeleitung 6 mit dem Ausgang 4 der Steuereinheit 2 verbunden ist. Die Steuereinheit 2 sendet die Impulse solange, bis sie das Taktsignal bzw. die Impulse wieder an ihrem Eingang 5 detektiert. Anhand der Anzahl der insgesamt erzeugten Takte bzw. Impulse kann die Steuereinheit die Anzahl der Netzwächter bzw. Überwachungseinrichtungen bestimmen.

Die Überwachungseinrichtungen 7a, 7b, 7c zählen während der Dauer der gesamten Routine alle Takte bzw. Impulse, die sie über ihre Signalaufbereitung 13 detektieren können. Sobald die Überwachungseinrichtungen 7ᵢ jeweils eine bestimmte Anzahl von Takten/Impulsen, z. B. insbesondere 2 oder 3 Takte/Impulse, gezählt haben, schließen sie ihr Schaltmittel 8, 8a, 8b, 8c. Die nachfolgende Überwachungseinrichtung 7ᵢ ist daraufhin wieder mit dem Ausgang 4 verbunden und "sieht" den erzeugten Takt bzw. die Impulse. Die Überwachungseinrichtungen 7, 7a, 7b, 7c hören nach dem Schließen ihres Schaltmittels 8, 8a, 8b, 8c nicht auf die ermittelten Takte bzw. Impulse zu zählen, bis die Steuereinheit 2 ein Dauersignal oder ein bestimmtes binäres oder analoges Code-Signal über die Meldeleitung 6 an die Überwachungseinrichtungen 7, 7a, 7b, 7c sendet. Die Anzahl der bis dahin gezählten Takte/Impulse bestimmt dann die jeweilige Adresse der Überwachungseinrichtung 7, 7a, 7b, 7c, welche in der Überwachungseinrichtung 7, 7a, 7b, 7c abgespeichert wird.

Der Adressiervorgang kann nach einer vorbestimmten Zeit automatisch oder durch ein von der Steuereinheit durch Senden eines Befehls beendet werden.

Die Kontrolle der Netzwächterfunktion kann dann selektiv erfolgen. Hierzu kann die Steuereinheit eine bestimmte Adresse und ein Befehlswort über die Meldeleitung 6 an die Überwachungseinrichtungen 7 senden. Der angewählte Elektronikbaustein öffnet daraufhin sein internes Schaltmittel 8 und löst damit den zugeordneten Netzwächter Nᵢ aus. Über den Eingang 18 erkennt die Steuereinrichtung 12 der Überwachungseinrichtung 7 ob das Netzwächter-Schaltmittel NSWᵢ ausgelöst hat und funktioniert. Wenn dies der Fall ist, sendet die ausgewählte Überwachungseinrichtung 7 eine bestimmte Bitfolge, z. B. 255, als positive Antwort an den Eingang 5 der Steuereinheit 2. Ein Fehlen der Antwort wird von der Steuereinheit 2 als defekter angewählter Netzwächter Nᵢ interpretiert. Selbstverständlich kann die ausgewählte Überwachungseinrichtung 7ᵢ auch eine bestimmte Bitfolge, z. B. 128, als Antwort für einen fehlerhaften Netzwächter Nᵢ an den Eingang 5 der Steuereinheit 2 senden.

## Patentansprüche

1. System zur Überwachung von mindestens zwei Netzwächtern (Nₐ, N_{b}, N_{c}), wobei das System eine Steuereinheit (2) und eine elektrische Meldeleitung (6) sowie mindestens zwei Netzwächter (Nₐ, N_{b}, N_{c}) aufweist, wobei jeder Netzwächter (Nₐ, N_{b}, N_{c}) jeweils ein Netzwächter-Schaltmittel (NSWₐ, NSW_{b}, NSW_{c}) aufweist, mit dem die elektrische Meldeleitung (6) unterbrechbar ist, sobald der Netzwächter (Nₐ, N_{b}, N_{c}) einen zu großen Spannungsabfall oder Spannungsausfall an zumindest einer elektrischen Versorgungsleitung (3a, 3b, 3c) detektiert, und die Meldeleitung (6) mit ihren Enden mit einem Ausgang (4) und einem Eingang (5) der Steuereinheit (2) verbunden ist, wobei die Steuereinheit (2) bei detektierter Unterbrechung der Meldeleitung (6) eine Aktion auslöst, **dadurch gekennzeichnet, dass** jedem Netzwächter (Nₐ, N_{b}, N_{c}) eine Überwachungseinrichtung (7, 7a, 7b, 7c) zugeordnet ist, wobei diese extern zum Netzwächter (Nₐ, N_{b}, N_{c}) angeordnet oder im Netzwächter (Nₐ, N_{b}, N_{c}) selbst integriert ist, und mittels der Steuereinheit (2) in Zusammenwirken mit den jeweiligen Überwachungseinrichtungen (7, 7a, 7b, 7c) die Funktion und/oder Funktionstüchtigkeit der Netzwächter (Nₐ, N_{b}, N_{c}) überprüfbar ist, wobei hierzu die Steuereinheit (2) entweder über die Meldeleitung (6), eine gesonderte Leitung oder über eine Funkübertragungsstrecke mit den Überwachungseinrichtungen (7, 7a, 7b, 7c) kommuniziert, und dass jede Überwachungseinrichtung (7, 7a, 7b, 7c) eine Steuereinrichtung (12) aufweist, welche ein Schaltmittel (8, 8a, 8b, 8c) ansteuert, wobei mittels des Schaltmittels (8, 8a, 8b, 8c) die Meldeleitung (6) unterbrechbar ist und die Überwachungseinrichtung (7, 7a, 7b, 7c) mindestens ein Test-Schaltmittel (9, 9a, 9b, 9c) zur wahlweisen Unterbrechung einer zu überwachenden Versorgungsleitung aufweist, wobei die Steuereinrichtung (12) der Überwachungseinrichtung (7, 7a, 7b, 7c) das Test-Schaltmittel (9, 9a, 9b, 9c) steuert.

2. System nach Anspruch 1, **dadurch gekennzeichnet, dass** die Meldeleitung (6) eine einpolige elektrische Meldeleitung ist, wobei die Leitungsabschnitte (6a, 6a*'*, 6b, 6b*'*, 6c, 6c*'*, 6d) der Meldeleitung (6) mit den Schaltmitteln der Netzwächter (Nₐ, N_{b}, N_{c}) in Reihe geschaltet ist.

3. System nach Anspruch 1, **dadurch gekennzei**c**hnet,** dass das Schaltmittel ein gesonderter Schalter in Form eines elektronischen oder elektromechanischen Schalters (8, 8a, 8b, 8c) ist oder das Netzwächter-Schaltmittel ist (NSWₐ, NSW_{b}, NSW_{c}).

4. System nach einem der Ansprüche 1 oder 3, **dadurch gekennzeichnet, dass** die Steuereinrichtung (12) der Überwachungseinrichtung (7, 7a, 7b, 7c) den Verlauf eines an der Meldeleitung anliegenden, insbesondere von der Steuereinheit (2) erzeugten, Signals verfolgt und in Abhängigkeit des Signals und/oder des Signalverlaufs das Schaltmittel (8, 8a, 8b, 8c) steuert.

5. System nach einem der vorhergehenden Ansprüche, **dadurch gekennzeichnet, dass** sich die Überwachungseinrichtung (7, 7a, 7b, 7c) über die zu überwachende Versorgungsleitung (3a, 3b, 3c) mit elektrischer Energie versorgt.

6. System nach einem der vorhergehenden Ansprüche, **dadurch gekennzeichnet, dass** die Überwachungseinrichtung (7, 7a, 7b, 7c) Mittel zur Ermittlung des Spannungsabfalls am Netzwächter-Schaltmittel (NSWₐ, NSW_{b}, NSW_{c}) oder zur Durchgangsprüfung des Netzwächter-Schaltmittels (NSWₐ, NSW_{b}, NSW_{c}) aufweist.

7. System nach einem der vorhergehenden Ansprüche, **dadurch gekennzeichnet, dass** mittels der Steuereinheit über die Meldeleitung die mindestens zwei Überwachungseinrichtungen (7, 7a, 7b, 7c) steuerbar- und/oder programmierbar und/oder adressierbar sind.

8. System nach einem der vorhergehenden Ansprüche, **dadurch gekennzeichnet, dass** jeder Überwachungseinrichtung (7, 7a, 7b, 7c) eine gesonderte Adresse zugeordnet ist und/oder zuordbar ist.

9. System nach einem der vorhergehenden Ansprüche, **dadurch gekennzeichnet, dass** die Steuereinrichtung (12) der Überwachungseinrichtung (7, 7a, 7b, 7c) den Verlauf eines an der Meldeleitung anliegenden, insbesondere von der Steuereinheit (2) erzeugten, Signals verfolgt und in Abhängigkeit des Signals und/oder des Signalverlaufs bestimmte Funktionen ausführt.

10. Verfahren zur Überwachung der Netzwächter eines Systems nach einem der vorhergehenden Ansprüche, **dadurch gekennzeichnet, dass** zur Adressierung der Überwachungseinrichtungen (7, 7a, 7b, 7c) die Steuereinheit (2) zunächst ein bestimmtes Signal, insbesondere in Form eines binären Codewortes über die Meldeleitung (6) an die Überwachungseinrichtungen (7, 7a, 7b, 7c) sendet, worauf diese ihr Schaltmittel (8, 8a, 8b, 8c) öffnen, derart, dass lediglich nur noch die in der Reihe erste Überwachungseinrichtung (7, 7a, 7b, 7c) über die Meldeleitung (6) mit dem Ausgang (4) der Steuereinheit (2) verbunden ist, und dass danach die Steuereinheit (2) ein Taktsignal oder Impulse über ihren Ausgang (4) zumindest solange auf die Meldeleitung (6) gibt, bis die Steuereinheit (2) an ihrem Eingang (5) das Taktsignal oder die Impulse detektiert, wobei die Überwachungseinrichtungen (7, 7a, 7b, 7c) jeweils mindestens einen Takt bzw. Impuls, insbesondere 2 oder 3 Takte/Impulse zählen und dann ihr Schaltmittel (8, 8a, 8b, 8c) schließen, wobei die Überwachungseinrichtungen (7, 7a, 7b, 7c) die ermittelten Takte bzw. Impulse solange zählen, bis die Steuereinheit (2) ein Dauersignal oder ein bestimmtes binäres oder analoges Code-Signal über die Meldeleitung (6) an die Überwachungseinrichtungen (7, 7a, 7b, 7c) sendet, wobei die von der jeweiligen Überwachungseinrichtung (7, 7a, 7b, 7c) gezählte Anzahl an Takten oder Impulsen die jeweilige Adresse der Überwachungseinrichtung (7, 7a, 7b, 7c) bestimmt, welche in der Überwachungseinrichtung (7, 7a, 7b, 7c) abgespeichert wird.

11. Verfahren nach Anspruch 10, **dadurch gekennzeichnet, dass** die Steuereinheit (2) die insgesamt ausgesendeten Takte oder Impulse zählt und anhand der Gesamtzahl die Anzahl der vorhandenen Überwachungseinrichtungen (7, 7a, 7b, 7c) bestimmt.

12. Verfahren nach einem der Ansprüche 10 oder 11, **dadurch gekennzeichnet, dass** die Steuereinheit (2) zum Testen der Netzwächter (Nₐ, N_{b}, N_{c}) eine Überwachungseinrichtung (7, 7a, 7b, 7c) durch Übermittlung einer Adresse über die Meldeleitung (6) auswählt und danach alle Überwachungseinrichtungen (7, 7a, 7b, 7c) ihre Schaltmittel (8, 8a, 8b, 8c) schließen oder geschlossen halten und die ausgewählte Überwachungseinrichtung (7, 7a, 7b, 7c) für eine vorbestimmte Zeit sein Test-Schaltmittel (9, 9a, 9b, 9c) für eine vorbestimmte Zeit öffnet und dann wieder schließt und damit den zugehörigen Netzwächter (Nₐ, N_{b}, N_{c}) testet.

13. Verfahren nach Anspruch 12, **dadurch gekennzeichnet, dass** die Steuereinheit (2) nach dem Übermitteln einer Adresse über die Meldeleitung (6) an die Überwachungseinrichtungen (7, 7a, 7b, 7c) an ihren Ausgang (4) ein von Null verschiedenes Spannungssignal anlegt.

14. Verfahren nach Anspruch 12 oder 13, **dadurch gekennzeichnet, dass** die Steuereinheit (2) ihren Eingang (5) auf eine Unterbrechung eines an ihrem Ausgang (4) angelegten Signals überwacht und eine kurzzeitige Unterbrechung als bestandener Funktionstest des gerade überprüften Netzwächters (Nₐ, N_{b}, N_{c}) wertet und die ausbleibende Unterbrechung als "Defekt" des gerade überprüften Netzwächters (Nₐ, N_{b}, N_{c}) wertet.

15. Verfahren nach Anspruch 12 oder 13, **dadurch gekennzeichnet, dass** die ausgewählte Überwachungseinrichtung (7, 7a, 7b, 7c) überprüft, ob das Netzwächter-Schaltmittel (NSWₐ, NSW_{b}, NSW_{c}) beim Öffnen des Test-Schaltmittels vom Netzwächter (Nₐ, N_{b}, N_{c}) geöffnet wird, und nach dem Schließen des Test-Schaltmittels (9, 9a, 9b, 9c) mittels des Schaltmittels (8, 8a, 8b, 8c) einen entsprechenden Funktionscode an den Eingang (5) der Steuereinheit (2) übermittelt.

16. Verfahren nach einem der Ansprüche 12 bis 15, **dadurch gekennzeichnet, dass** die Überprüfung eines Netzwächters nach einer bestimmten Zeit automatisch beendet ist und die Überwachungseinrichtung (7, 7a, 7b, 7c) automatisch wieder in den Ausgangszustand zurückkehrt oder die Steuereinheit die Überprüfung durch das Senden eines Ende-Codes beendet.

17. Verfahren nach einem der Ansprüche 10 bis 13, **dadurch gekennzeichnet, dass** zur Überprüfung der einzelnen Netzwächter (Nₐ, N_{b}, N_{c}) die Steuereinheit ein Taktsignal, insbesondere ein Rechtecksignal, an seinem Ausgang erzeugt, welches über die Meldeleitung den Überwachungseinrichtungen (7, 7a, 7b, 7c) zugeleitet wird, wobei die Überwachungseinrichtungen (7, 7a, 7b, 7c) nach dem Empfang einer vorbestimmten Anzahl von Takten oder Impulsen ihr Test-Schaltmittel (9, 9a, 9b, 9c) öffnen und somit den zugehörigen Netzwächter (Nₐ, N_{b}, N_{c}) auslösen, welcher wiederum das Netzwächter-Schaltmittel (NSWₐ, NSW_{b}, NSW_{c}) öffnet, wodurch das Taktsignal von der Steuereinheit nur noch am Eingang der in der Reihe ersten Überwachungseinrichtung (7, 7a, 7b, 7c) anliegt, und dass danach die Steuereinheit solange ein Taktsignal oder Impulse über ihren Ausgang auf die Meldeleitung gibt, bis die Steuereinheit an ihrem Eingang das Taktsignal oder die Impulse detektiert, wobei die Überwachungseinrichtungen (7, 7a, 7b, 7c) jeweils mindestens einen Takt bzw. Impuls, insbesondere 2 oder 3 Takte/Impulse zählen und dann ihr Test-Schaltmittel (9, 9a, 9b, 9c) schlieβen, wodurch der zugehörige Netzwächter (Nₐ, N_{b}, N_{c}), sofern funktionstüchtig, sein Netzwächter-Schaltmittel (NSWₐ, NSW_{b}, NSW_{c}) schließt und das Taktsignal bzw. die Impulse am Eingang der nächsten Überwachungseinrichtung (7, 7a, 7b, 7c) anliegen, woraufhin auch diese mindestens einen Takt bzw. Impuls, insbesondere 2 oder 3 Takte/Impulse zählt und dann ihr Test-Schaltmittel (9, 9a, 9b, 9c) schließt.

18. Verfahren nach Anspruch 17, **dadurch gekennzeichnet, dass** die Steuereinheit (2) die Anzahl der ausgesendeten Takte bzw. Impulse zählt, bis am Eingang (5) der Steuereinheit (2) die Takte bzw. Impulse detektiert werden, nach dem das letzte Netzwächter-Schaltmittel (NSWₐ, NSW_{b}, NSW_{c}) geschlossen ist, und dass dann anhand eines Vergleichs der gezählten Anzahl von Takten/Impulsen mit einem abgespeicherten Wert die Funktionstüchtigkeit aller Netzwächter (Nₐ, N_{b}, N_{c}) ermittelt wird und gegebenenfalls ein Alarm oder Alarmsignal ausgelöst wird.

19. Verfahren nach einem der Ansprüche 13 bis 18, **dadurch gekennzeichnet, dass** zur Überprüfung der einzelnen Netzwächter (Nₐ, N_{b}, N_{c}) die Steuereinheit (2) in vorbestimmten Zeitintervallen, insbesondere jeden Tag, jede Woche oder jeden Monat, oder auf ein bestimmtes Auslösesignal hin die Netzwächterüberprüfung durchführt.

## Claims

1. System for monitoring at least two mains voltage sensors (Nₐ, N_{b}, N_{c}), whereby the system has a control unit (2) and an electrical communication line (6) and at least two mains voltage sensors (Nₐ, N_{b}, N_{c}), whereby each mains voltage sensor (Nₐ, N_{b}, N_{c}) has a mains voltage sensor switching device (NSWₐ, NSW_{b}, NSW_{c}) by means of which the electrical communication line (6) can be interrupted as soon as the mains voltage sensor (Nₐ, Nb, NJ detects a drop in voltage or failure in voltage on at least one electrical supply line (3a, 3b, 3c) and the ends of the communication line (6) are connected to an output (4) and an input (5) of the control unit (2), whereby when an interruption in the communication line (6) is detected the control unit (2) triggers an action, **characterised in that** each mains voltage sensor (Nₐ, N_{b}, N_{c}) is assigned a monitoring device (7, 7a, 7b, 7c), whereby this is arranged external to the mains voltage sensor (Nₐ, N_{b}, N_{c}) or is integrated into the mains voltage sensor itself (Nₐ, N_{b}, N_{c}) and by means of the control unit (2) interacting with the respective monitoring devices (7, 7a, 7b, 7c) the function and/or functionality of the mains voltage sensors (Nₐ, N_{b}, N_{c}) can be checked, whereby in order to do this the control unit (2) communicates with the monitoring devices (7, 7a, 7b, 7c) either via the communication line (6), a separate line or a radio transmission route, and **in that** each monitoring device (7, 7a, 7b, 7c) has a control device (12) which controls a switching device (8, 8a, 8b, 8c), whereby the communication line (6) can be interrupted by means of the switching device (8, 8a, 8b, 8c) and the monitoring device (7, 7a, 7b, 7c) has at least one test switching device (9, 9a, 9b, 9c) for the optional interruption of a supply line to be monitored, whereby the control device (12) of the monitoring device (7, 7a, 7b, 7c) controls the test switching device (9, 9a, 9b, 9c).

2. System according to Claim 1, **characterised in that** the communication line (6) is a unipolar electrical communication line, whereby the line sections (6a, 6a", 6b, 61D", 6c, 6c", 6d) of the communication line are connected in series with the switching device of the mains voltage sensors (Nₐ, N_{b}, N_{c}).

3. System according to Claim 1, **characterised in that** the switching device is a separate switch in the form of an electrical or electromechanical switch (8, 8a, 8b, 8c) or is the mains voltage sensor switching device (NSWₐ, NSW_{b}, NSW_{c}).

4. System according to either Claim 1 or Claim 3, **characterised in that** the control device (12) of the monitoring device (7, 7a, 7b, 7c) tracks the progression of a signal present at the communication line, in particular generated by the control unit (2) and controls the switching device (8, 8a, 8b, 8c) depending on the signal and/or the signal progression.

5. System according to any one of the preceding claims, **characterised in that** the monitoring device (7, 7a, 7b, 7c) supplies the supply line (3a, 3b, 3v) to be monitored with electrical energy.

6. System according to any one of the preceding claims, **characterised in that** the monitoring device (7, 7a, 7b, 7c) has means to determine the drop in voltage on the mains voltage sensor switching device (NSWₐ, NSW_{b}, NSW_{c}) or to test the continuity of the mains voltage sensor switching device (NSWₐ, NSW_{b}, NSW_{c}).

7. System according to any one of the preceding claims, **characterised in that** the at least two monitoring devices (7, 7a, 7b, 7c) can be controlled and/or programmed and/or addressed by means of the control unit via the communication line.

8. System according to any one of the preceding claims, **characterised in that** each monitoring device (7, 7a, 7b, 7c) is assigned and/or can be assigned a separate address.

9. System according to any one of the preceding claims, **characterised in that** the control device (12) of the monitoring device (7, 7a, 7b, 7c) tracks the progression of a signal attached to the communication line, in particular generated by the control unit (2) and carries out certain functions depending on the signal and/or the signal progression.

10. Method for monitoring the mains voltage sensor of a system according to any one of the preceding claims, **characterised in that** in order to address the monitoring devices (7, 7a, 7b, 7c) the control unit (2) first transmits a certain signal, in particular in the form of a binary code word, via the communication line (6) to the monitoring devices (7, 7a, 7b, 7c), as a result of which these switch their switching devices (8, 8a, 8b, 8c) to the open position such that only the monitoring device (7, 7a, 7b, 7c) that is first in the series is connected to the output (4) of the control unit (2) via the communication line (6), and **in that** after this the control unit (2) emits a clock signal or impulse via its output (4) on the communication line (6) until the control unit (2) detects the clock signal or impulse at its input (5), whereby the monitoring devices (7, 7a, 7b, 7c) each count at least one stroke or impulse, in particular 2 or 3 strokes/impulse and then switch their switching devices (8, 8a, 8b, 8c) to the closed position, whereby the monitoring devices (7, 7a, 7b, 7c) count the strokes or impulse until the control unit (2) is transmitting a constant signal or a certain binary or analogue code signal to the monitoring devices (7, 7a, 7b, 7c) via the communication line (6), whereby the number of strokes or impulse counted by the respective monitoring device (7, 7a, 7b, 7c) determines the respective address of the monitoring device (7, 7a, 7b, 7c) which is saved in the monitoring device (7, 7a, 7b, 7c).

11. Method according to Claim 10, **characterised in that** the control unit (2) counts the total strokes or impulse emitted and using the total number of strokes or impulses to determine the number of monitoring devices (7, 7a, 7b, 7c) present.

12. Method according to either Claim 10 or 11, **characterised in that** in order to test the mains voltage sensor (Nₐ, N_{b}, N_{c}) the control unit (2) selected a monitoring device (7, 7a, 7b, 7c) by transmitting an address via the communication line (6) and then all of the monitoring devices (7, 7a, 7b, 7c) close their switching devices (8, 8a, 8b, 8c) or keep them closed and the selected monitoring device (7, 7a, 7b, 7c) opens its test switching devices (9, 9a, 9b, 9c) for a predetermined time then close it again and thereby testing the corresponding mains voltage sensor (Nₐ, N_{b}, N_{c}).

13. Method according to Claim 12, **characterised in that** the control unit (2) creates a voltage signal that differs from zero at the output (4) of the monitoring devices (7, 7a, 7b, 7c) via the communication line (6) after transmitting an address.

14. Method according to either Claim 12 or 13, **characterised in that** the control unit (2) monitors its output (5) for an interruption of a signal created at its output (4) and a short interruption is deemed to be a passed functional test of the mains voltage sensor (Nₐ, N_{b}, N_{c}) that has just been tested and a lack of interruption is deemed to be a "defect" of the mains voltage sensor (Nₐ, N_{b}, N_{c}) that has just been tested.

15. Method according to Claim 12 or 13, **characterised in that** the selected monitoring device (7, 7a, 7b, 7c) tests whether the mains voltage sensor switching device (NSWₐ, NSW_{b}, NSW_{c}) is opened by the mains voltage sensor (Nₐ, N_{b}, N_{c}) when the test switching devices is switched on and whether after the test switching device (9, 9a, 9b, 9c) has been closed by the switching device (8, 8a, 8b, 8c) a corresponding function code is transmitted to the input (5) of the control unit (2).

16. Method according to any one of Claims 12 to 15, **characterised in that** the testing of a mains voltage sensor is automatically ended after a certain period of time and the monitoring device (7, 7a, 7b, 7c) automatically returns to the initial state or the control unit ends the test by sending an end code.

17. Method according to any one of Claims 10 to 13, **characterised in that** to test the individual mains voltage sensor (Nₐ, N_{b}, N_{c}) the control unit generates a clock signal, in particular a square-wave signal, at its output which is fed to the monitoring devices (7, 7a, 7b, 7c) via the connection line, whereby after receiving a predetermined number of strokes or impulse the monitoring devices (7, 7a, 7b, 7c) open their test switching devices (9, 9a, 9b, 9c), thereby triggering the corresponding mains voltage sensor (Nₐ, N_{b}, N_{c}), which opens its mains voltage sensor switch (NSWₐ, NSW_{b}, NSW_{c}) resulting in the clock signal from the control unit only being present at the input of the monitoring device (7, 7a, 7b, 7c) that is first in the series, and **in that** the control unit then transmits a clock signal or impulse via its output on the communication line until the control unit detects the clock signal or the impulse at its input, whereby the monitoring units (7, 7a, 7b, 7c) each count at least one stroke or impulse, in particular 2 or 3 strokes/impulses and then close their test switching device (9, 9a, 9b, 9c), resulting in the corresponding mains voltage sensor (Nₐ, N_{b}, N_{c}), where this is functional, closes its mains voltage switching device (NSWₐ, NSW_{b}, NSW_{c}) and the clock signal or impulse being present at the input of the next monitoring device (7, 7a, 7b, 7c), as a result of which this also counts at least one stroke or impulse, in particular 2 or 3 strokes/impulses and then closes its test switching device (9, 9a, 9b, 9c).

18. Method according to Claim 17, **characterised in that** the control unit (2) counts the number of strokes or impulses transmitted until the strokes or impulses are detected at the input (5) of the control unit (2) after the final mains voltage sensor switching device (NSWₐ, NSW_{b}, NSW_{c}) has been closed, and **in that** then a comparison of the number of strokes/impulses counted with the saved value is used to determine the functionality of all mains voltage sensors (Nₐ, N_{b}, N_{c}) and where applicable an alarm or alarm signal is triggered.

19. Method according to any one of Claims 13 to 18, **characterised in that** in order to test the individual mains voltage sensors (Nₐ, N_{b}, N_{c}) the control unit (2) carries out the mains voltage sensor test at predetermined intervals, in particular every day, every week or every month or in response to a certain trigger signal.

## Revendications

1. Système de surveillance doté d'au moins deux contrôleurs de réseau (Nₐ, N_{b}, N_{c}), le système présentant une unité de commande (2) et une conduite de signalisation électrique (6) ainsi que deux contrôleurs de réseau (Nₐ, N_{b}, N_{c}) au moins, chaque contrôleur de réseau (Nₐ, N_{b}, N_{c}) présentant respectivement un commutateur de contrôleur de réseau (NSWₐ, NSW_{b}, NSW_{c}) au moyen duquel la conduite de signalisation électrique (6) peut être interrompue dès que le contrôleur de réseau (Nₐ, N_{b}, N_{c}) détecte une chute de tension trop importante ou une rupture de tension dans au moins une conduite d'alimentation électrique (3a, 3b, 3c), la conduite de signalisation (6) étant reliée, en ses extrémités, à une sortie (4) et à une entrée (5) de l'unité de commande (2), l'unité de commande (2) déclenchant une action en cas de détection d'une interruption de la conduite de signalisation (6), **caractérisé en ce qu**'une installation de surveillance (7, 7a, 7b, 7c) est affectée à chaque contrôleur de réseau (Nₐ, N_{b}, N_{c}), celle-ci étant placée à l'extérieur du contrôleur de réseau (Nₐ, N_{b}, N_{c}) ou intégrée dans le contrôleur de réseau (Nₐ, N_{b}, N_{c}) et la fonction et/ou la fonctionnalité des contrôleurs de réseau (Nₐ, N_{b}, N_{c}) pouvant être contrôlée à l'aide de l'unité de commande (2), conjointement avec les installations de surveillance respectives (7, 7a, 7b, 7c), l'unité de commande (2) communiquant pour ce faire soit au moyen de la conduite de signalisation (6), une conduite séparée, soit encore au moyen d'une ligne de transmission via radio avec les installations de surveillance (7, 7a, 7b, 7c) et chaque installation de surveillance (7, 7a, 7b, 7c) présentant un moyen de commande (12) qui actionne un commutateur (8, 8a, 8b, 8c), la conduite de signalisation (6) pouvant être interrompue par le commutateur (8, 8a, 8b, 8c) et l'installation de surveillance (7, 7a, 7b, 7c) présentant au moins un commutateur de test (9, 9a, 9b, 9c) pour l'interruption au choix d'une conduite d'alimentation à surveiller, le moyen de commande (12) de l'installation de surveillance (7, 7a, 7b, 7c) commandant le commutateur de test (9, 9a, 9b, 9c).

2. Système selon la revendication 1, **caractérisé en ce que** la conduite de signalisation (6) est une conduite de signalisation électrique unipolaire, les tronçons de conduite (6a, 6a', 6b, 6b', 6c, 6c',6d) de la conduite de signalisation (6) étant reliés en série aux commutateurs du contrôleur de réseau (Nₐ, N_{b}, N_{c}).

3. Système selon la revendication 1, **caractérisé en ce que** le commutateur est un commutateur distinct, sous la forme d'un commutateur électronique ou électromécanique (8, 8a, 8b, 8c), ou encore est le commutateur du contrôleur de réseau (NSWₐ, NSW_{b}, NSW_{c}).

4. Système selon la revendication 1 ou 3, **caractérisé en ce que** le moyen de commande (12) de l'installation de surveillance (7, 7a, 7b, 7c) suit la courbe d'un signal appliqué sur la conduite de signalisation, produit notamment par l'unité de commande (2) et commande le commutateur (8, 8a, 8b, 8c) en fonction du signal et/ou de la courbe du signal.

5. Système selon l'une quelconque des revendications précédentes, **caractérisé en ce que** l'installation de surveillance (7, 7a, 7b, 7c) s'alimente en énergie électrique au moyen de la conduite d'alimentation à surveiller (3a, 3b, 3c).

6. Système selon l'une quelconque des revendications précédentes, **caractérisé en ce que** l'installation de surveillance (7, 7a, 7b, 7c) présente des moyens pour la détection de la chute de tension au niveau du commutateur du contrôleur de réseau (NSWₐ, NSW_{b}, NSW_{c}) ou pour le test de continuité du commutateur de contrôleur de réseau (NSWₐ, NSW_{b}, NSW_{c}).

7. Système selon l'une quelconque des revendications précédentes, **caractérisé en ce que** les deux installations de surveillance au moins (7, 7a, 7b, 7c) sont contrôlables et/ou programmables et/ou adressables au moyen de l'unité de commande via la conduite de signalisation.

8. Système selon l'une quelconque des revendications précédentes, **caractérisé en ce que** chaque installation de surveillance (7, 7a, 7b, 7c) a, ou peut avoir une adresse séparée.

9. Système selon l'une quelconque des revendications précédentes, **caractérisé en ce que** le moyen de commande (12) de l'installation de surveillance (7, 7a, 7b, 7c) suit la courbe d'un signal appliqué sur la conduite de signalisation, produit notamment par l'unité de commande (2) et exécute certaines fonctions en fonction du signal et/ou de la courbe du signal.

10. Procédé pour la surveillance des dispositifs de surveillance d'un système selon l'une quelconque des revendications précédentes, **caractérisé en ce que,** pour l'adressage de l'installation de surveillance (7, 7a, 7b, 7c), l'unité de commande (2) envoie dans un premier temps un signal donné, en particulier sous la forme de code binaire, via la conduite de signalisation (6), aux installations de surveillance (7, 7a, 7b, 7c), à la suite de quoi celles-ci ouvrent leur commutateur (8, 8a, 8b, 8c) de façon à ce que seule la première installation de surveillance de la série soit reliée à la sortie (4) de l'unité de commande (2) au moyen de la conduite de signalisation (6), et à ce que l'unité de commande (2) donne ensuite un signal d'horloge ou des impulsions à sa sortie (4), sur la conduite de signalisation (6), au moins jusqu'à ce que l'unité de commande (2) détecte à son entrée (5) le signal d'horloge ou les impulsions, les installations de surveillance (7, 7a, 7b, 7c) comptant respectivement au moins une cadence ou une impulsion, en particulier 2 ou 3 cadences et/ou impulsions et ferment ensuite leur commutateur (8, 8a, 8b, 8c), les installations de surveillance (7, 7a, 7b, 7c) comptant les signaux d'horloge ou les impulsions jusqu'à ce que l'unité de commande (2) envoie un signal continu ou un signal codé binaire ou analogique donné, via la conduite de signalisation (6), aux installations de surveillance (7, 7a, 7b, 7c), le nombre de cadences ou d'impulsions comptées par l'installation de surveillance respective (7, 7a, 7b, 7c) déterminant l'adresse respective de l'installation de surveillance (7, 7a, 7b, 7c), qui est enregistrée dans l'installation de surveillance (7, 7a, 7b, 7c).

11. Procédé selon la revendication 10, **caractérisé en ce que** l'unité de commande (2) compte le nombre total de cadences ou d'impulsions envoyées et, à partir du nombre total, détermine le nombre d'installations de surveillance présentes (7, 7a, 7b, 7c).

12. Procédé selon l'une quelconque des revendications 10 ou 11, **caractérisé en ce que** l'unité de commande (2) sélectionne une installation de surveillance (7, 7a, 7b, 7c) pour tester les contrôleurs de réseau (Nₐ, N_{b}, N_{c}) en fournissant une adresse via la conduite de signalisation (6), et **en ce que**, ensuite, toutes les installations de surveillance (7, 7a, 7b, 7c) ferment ou maintiennent fermés leurs commutateurs (8, 8a, 8b, 8c) et l'installation de surveillance choisie (7, 7a, 7b, 7c) ouvre pendant une durée prédéterminée son commutateur de test (9, 9a, 9b, 9c) et le referme ensuite en testant ainsi le contrôleur de réseau respectif (Nₐ, N_{b}, N_{c}).

13. Procédé selon la revendication 12, **caractérisé en ce que** l'unité de commande (2) applique un signal de tension différent de zéro après la transmission d'une adresse, au moyen de la conduite de signalisation (6), aux installations de surveillance (7, 7a, 7b, 7c) à leur sortie (4).

14. Procédé selon l'une quelconque des revendications 12 ou 13, **caractérisé en ce que** l'unité de commande (2) surveille son entrée (5) pour déceler une interruption du signal appliqué à sa sortie (4) et considère une brève interruption comme un test fonctionnel réussi du contrôleur de réseau (Nₐ, N_{b}, N_{c}) venant d'être contrôlé, et l'absence d'interruption comme une « défaillance » du contrôleur de réseau (Nₐ, N_{b}, N_{c}) venant d'être contrôlé.

15. Procédé selon l'une quelconque des revendications 12 ou 13, **caractérisé en ce que** l'installation de surveillance choisie (7, 7a, 7b, 7c) contrôle si le commutateur du contrôleur de réseau (NSWₐ, NSW_{b}, NSW_{c}) s'ouvre à l'ouverture du commutateur de test du contrôleur de réseau (Nₐ, N_{b}, N_{c}) et, après la fermeture du commutateur de test (9, 9a, 9b, 9c) par le commutateur (8, 8a, 8b, 8c), transmet un code de fonction correspondant à l'entrée (5) de l'unité de commande (2).

16. Procédé selon l'une quelconque des revendications 12 à 15, **caractérisé en ce que** le contrôle d'un contrôleur de réseau se termine automatiquement après un certain temps et l'installation de surveillance (7, 7a, 7b, 7c) retourne automatiquement à l'état initial ou l'unité de commande termine le contrôle en envoyant un code de fin.

17. Procédé selon l'une quelconque des revendications 10 à 13, **caractérisé en ce que,** pour le contrôle de chaque contrôleur de réseau (Nₐ, N_{b}, N_{c}), l'unité de commande produit un signal d'horloge, notamment un signal rectangulaire, à sa sortie, lequel signal est acheminé vers les installations de surveillance (7, 7a, 7b, 7c) via la conduite de signalisation, les installations de surveillance (7, 7a, 7b, 7c) ouvrant leur commutateur de test (9, 9a, 9b, 9c) après la réception d'un nombre prédéfini de cadences ou d'impulsions et déclenchant ainsi le contrôleur de réseau respectif (Nₐ, N_{b}, N_{c}), lequel ouvre à son tour le commutateur du contrôleur de réseau (NSWₐ, NSW_{b}, NSW_{c}), à la suite de quoi le signal d'horloge de l'unité de commande est appliqué seulement à l'entrée de la première installation de surveillance de la série (7, 7a, 7b, 7c) et l'unité de commande émet un signal d'horloge ou des impulsions via sa sortie sur la conduite de signalisation jusqu'à ce que l'unité de commande détecte à son entrée le signal d'horloge ou les impulsions, les installations de surveillance (7, 7a, 7b, 7c) comptant respectivement au moins une cadence ou impulsion, en particulier, 2 ou 3 cadences/impulsions, et fermant ensuite leur commutateur de test (9, 9a, 9b, 9c), à la suite de quoi le contrôleur de réseau (Nₐ, N_{b}, N_{c}) respectif, si fonctionnel, ferme son commutateur de contrôleur de réseau (NSWₐ, NSW_{b}, NSW_{c}) et le signal d'horloge ou les impulsions sont appliqués à l'entrée de l'installation de surveillance suivante (7, 7a, 7b, 7c), celle-ci comptant au moins une cadence/impulsion, en particulier 2 ou 3 cadences/impulsions, et fermant ensuite son commutateur de test (9, 9a, 9b, 9c).

18. Procédé selon la revendication 17, **caractérisé en ce que** l'unité de commande (2) compte le nombre de cadences ou d'impulsions envoyées jusqu'à ce que les cadences ou impulsions soient détectées à l'entrée (5) de l'unité de commande (2), après la fermeture du dernier commutateur de contrôleur de réseau (NSWₐ, NSW_{b}, NSW_{c}), et **en ce que** la fonctionnalité de tous les contrôleurs de réseau (Nₐ, N_{b}, N_{c}) est déterminée en comparant le nombre de cadences et/ou impulsions comptées à une valeur enregistrée et, le cas échéant, une alarme ou un signal d'alarme se déclenche.

19. Procédé selon l'une quelconque des revendications 13 à 18, **caractérisé en ce que,** pour le contrôle des différents contrôleurs de réseau (Nₐ, N_{b}, N_{c}), l'unité de commande (2) exécute le contrôle des contrôleurs de réseau à intervalles de temps prédéfinis, en particulier, tous les jours, toutes les semaines ou tous les mois ou bien à un signal de déclenchement donné.
